Europäisches Patentamt

European Patent Office

Office européen des brevets

(11) Veröffentlichungsnummer: **0 036 618**
**B1**

(12) **EUROPÄISCHE PATENTSCHRIFT**

(45) Veröffentlichungstag der Patentschrift: **09.01.85**

(51) Int. Cl.⁴: **H 01 J 37/06, H 01 L 21/263**

(21) Anmeldenummer: **81101987.6**

(22) Anmeldetag: **17.03.81**

(54) **Hochstrom-Elektronenquelle.**

(30) Priorität: **20.03.80 DE 3010815**

(43) Veröffentlichungstag der Anmeldung:
**30.09.81 Patentblatt 81/39**

(45) Bekanntmachung des Hinweises auf die
Patenterteilung:
**09.01.85 Patentblatt 85/02**

(84) Benannte Vertragsstaaten:
**FR NL**

(56) Entgegenhaltungen:
**CH-A- 298 287**
**DD-A- 45 225**
**DE-A-2 627 632**
**GB-A-1 330 366**
**US-A-3 811 059**

(73) Patentinhaber: **Siemens Aktiengesellschaft**
**Berlin und München Wittelsbacherplatz 2**
**D-8000 München 2 (DE)**

(72) Erfinder: **Anger, Klaus, Dipl.-Ing.**
**Putzbrunner Strasse 123**
**D-8000 München 83 (DE)**
Erfinder: **Plies, Erich, Dr.**
**Deisenhofener Strasse 79**
**D-8000 München 90 (DE)**
Erfinder: **Frosien, Jürgen, Dipl.-Ing.**
**An der Ottosäule 18**
**D-8012 Ottobrunn (DE)**
Erfinder: **Tonar, Klaus, Dipl.-Ing.**
**Hermannstrasse 1e**
**D-1000 Berlin 37 (DE)**
Erfinder: **Lischke, Burkhardt, Dr. Prof.**
**In der Heuluss 13**
**D-8000 München 82 (DE)**

Courier Press, Leamington Spa, England.

## Beschreibung

Die Erfindung betrifft eine Hochstrom-Elektronenquelle kleiner Energiebreite, insbesondere für einen Elektronenstrahlschreiber, mit einem Strahlerzeugungssystem, aus Kathode und weiteren Elektroden von denen eine als gehnelt-Elektrode die aus der Kathode austretenden, noch geringe Geschwindigkeiten aufweisenden Elektronen astigmatisch in eine linienförmige Kreuzungslinie (cross-over) fokussiert.

Es ist aus Experimenten bekannt, daß die vom Emissionsprozeß (z.B. thermische Emission, Schottky- oder Feldemission) zu erwartende niedrige Energiebreite nur bei ganz schwachen Strahlströmen erreicht wird. Mit wachsendem Strahlstrom tritt eine Verbreiterung der Energieverteilung der Elektronen auf, die sich durch Coulomb-Wechselwirkung der Elektronen im rellen cross-over des Strahlerzeugungssystems und/oder in Überkreuzungsbereichen nach der Anode erklären lassen. Insbesondere im Kathodenraum, wo die emittierten Elektronen noch sehr langsam sind, ist ihre Empfindlichkeit gegen derartige Coulomb-Wechselwirkungen besonders groß.

Nach Rechnungen von H. Rose (19. Tagung der Deutschen Gesellschaft für Elektronenmikroskopie vom 9.—14. Sept. 1979 in Tübingen) ist die Energieverbreiterung eines monoenergetischen Elektronenstrahlbündels, d.h. eines Elektronenstrahlbündels nach der Anode, nach Durchlaufen eines stigmatischen Überkreuzungspunktes wesentlich höher als nach Durchlaufen eines astigmatischen Überkreuzungsbereiches.

Weiterhin ist es auch bekannt, die Energieverbreiterung in reellen cross-over des Strahlerzeugungssystems bei Fernsehröhren dadurch herabzusetzen, daß durch eine Gitterelektrode mit einem Schlitz der bisherige Kreuzungspunkt durch zwei Kreuzungslinien mit geringer Elektronendichte ersetzt wird. Durch die Größe und die Lage des Schlitzes sind die Lagen und die Abmessungen der Kreuzungslinien festgelegt (VDI Nachrichten Nr. 5, 2. Febr. 1979, Seite 8).

Aus der Patentschrift CH 29 82 87 ist ein Strahlerzeugungssystem für Elektronenstrahl-Geräte bekannt, bei dem eine Wehnelt-Elektrode in Sektoren und eine Hilfselektrode in Sektoren unterteilt sind, an die je verschiedene Potentiale gelegt werden. So kann je nach Wahl dieser Potentiale sowohl die Richtung des Elektronenstrahls beeinflußt werden, also eine Schwenkung des Strahles vorgenommen werden, als auch die Form des Elektronenstrahls zweckentsprechend gewählt werden. Auf diese Weise kann ein länglicher, vorzugsweise nahezu strichförmiger Brennfleck erzeugt werden. Damit kann bei einer Röntgenröhre eine bessere Wärmeableitung des Brennfleckes erzielt werden. Eine Segmentierung der Wehnelt-Elektrode und der Hilfselektrode dient also bei diesem Stand der Technik einer besseren Wärmeableitung des Brennfleckes bei einer Röntgenröhre.

Der vorliegenden Erfindung liegt die Aufgabe zugrunde, bei einer Hochstrom-Elektronenquelle der eingangs genannten Art das Strahlerzeugungssystem derart zu gestalten, daß die Lagen und Formen der linienförmigen Kreuzungsbereiche auf einfache Weise in eine beliebige Richtung gedreht und verschoben werden können.

Diese Aufgabe wird erfindungsgemäß durch eine Hochstrom-Elektronenquelle nach dem Anspruch 1 gelöst. Oktupol-Elemente, mit deren Hilfe die Lagen und Formen der linienförmigen Kreuzungsbereiche auf einfache Weise in eine beliebige Richtung gedreht und verschoben werden können, können beispielsweise aus vier um jeweils 45° gegeneinander verdrehten Zylinderlinsen oder aus zwei um 45° gegeneinander verdrehten elektrostatischen Quadrupol-Elementen, deren Potentiale unabhängig voneinander veränderbar sind, oder aus zwei um 45° gegeneinander verdrehten elektromagnetischen Quadrupol-Elementen, die von unabhängig voneinander regelbaren Strömen durchflossen sind, und die eine Elektrode aus nichtferromagnetischem Material mit einer Öffnung für den Elektronenstrahl umgeben, aufgebaut sein.

Ein Oktupol-Element nach einer besonderen Ausführungsart der Erfindung kann aus zwei um 45° gegeneinander verdrehten Quadrupol-Elementen bestehen, deren Potentiale unabhängig voneinander veränderbar sind. Mit Hilfe dieses Oktupolelementes kann der linienförmige cross-over allein durch Wahl des Quotienten der Potentiale in eine beliebige Richtung gedreht werden. Außerdem läßt sich die Länge und die Breite des cross-over durch die gewählten Potentiale in gewissen Grenzen variieren.

In einer besonders vorteilhaften Anordnung ist eine Oktupolelement vorgesehen, das aus zwei um 45° gegeneinander verdrehten elektromagnetischen Quadrupolelementen aufgebaut ist, die von unabhängig voneinander erregbaren Strömen durchflossen sind. Mit Hilfe dieses Oktupolelementes läßt sich die Winkellage des cross-over beliebig drehen.

Die erfindungsgemäßen Hochstrom-Elektronenquellen lassen sich besonders vorteilhaft in Elektronenstrahlschreibern mit variabel geformten Sondenquerschnitten oder sogar nach charakteristischen Mustern geformten Sondenquerschnitten, wie sie beispielsweise aus "Proceedings of the Symposium on Electron and Ion Beam Science and Technology, 8th International Conference", Vol. 78—5, Seiten 149 bis 159 bekannt sind, einsetzen.

Bei diesen bekannten Elektronenstrahlschreibern ist die Bearbeitungszeit für die Belichtung einer ganzen Halbleiterscheibe mit einem vorgegebenen Muster durch die geformte Elektronenstrahlsonde bereits stark reduziert worden. Eine weitere Reduzierung dieser Arbeitszeit zur wirtschaftlichen Erzeugung einer Vielzahl von integrierten Halbleiterscheiben läßt sich—gleiche Elektronenresist-Empfindlichkeit vorausgesetzt—durch Steigerung der Elektronenstrahlstromdichte, d.h. durch Verwendung einer Hochstrom-Elektronenquelle, erzielen. Um dabei die Auflösung des Systems und damit die Kantenschärfe der abgebildeten Strukturen nicht zu verschlechtern, müssen die erzeugten Elektronen möglichst monoenergetisch sein. Die erfindungsgemäße Hochstrom-Elektronenquelle geringer Energiebreite eignet sich dafür hervorragend. Durch die einfache Möglichkeit, die Lage des Kreuzungsbereiches und seine Form zu verändern, läßt es sich erreichen, daß die verwendeten Masken im Strahlengang zur Erzeugung der geformten Elektronensonde nur im wesentlichen in den dem geforderten Muster entsprechenden Bereichen ausgeleuchtet werden. Bei den bisherigen Elektronenquellen wurden unausgenutzte Bereiche der Masken mit ausgeleuchtet, so daß sich insgesamt die Elektronendichte in dem letztlich zur Abbildung kommenden Sondenbereich verringerte.

Im folgenden wird anhand von in acht Figuren dargestellten Ausführungsbeispielen die Erfindung weiter beschrieben und erläutert. Dabei zeigt

Fig. 1 teilweise perspektivisch ein Prinzipbild eines Elektronenstrahlschreibers mit einer Hochstrom-Elektronenquelle;

Fig. 2a bis 2c zeigen das bekannte Strahlerzeugungssystem in zwei Ansichten und den sich damit ergebenden cross-over;

Fig. 4, 6 u. 8 zeigen drei verschiedene Strahlerzeugungssystem mit Oktupol-Systemen nach der Erfindung;

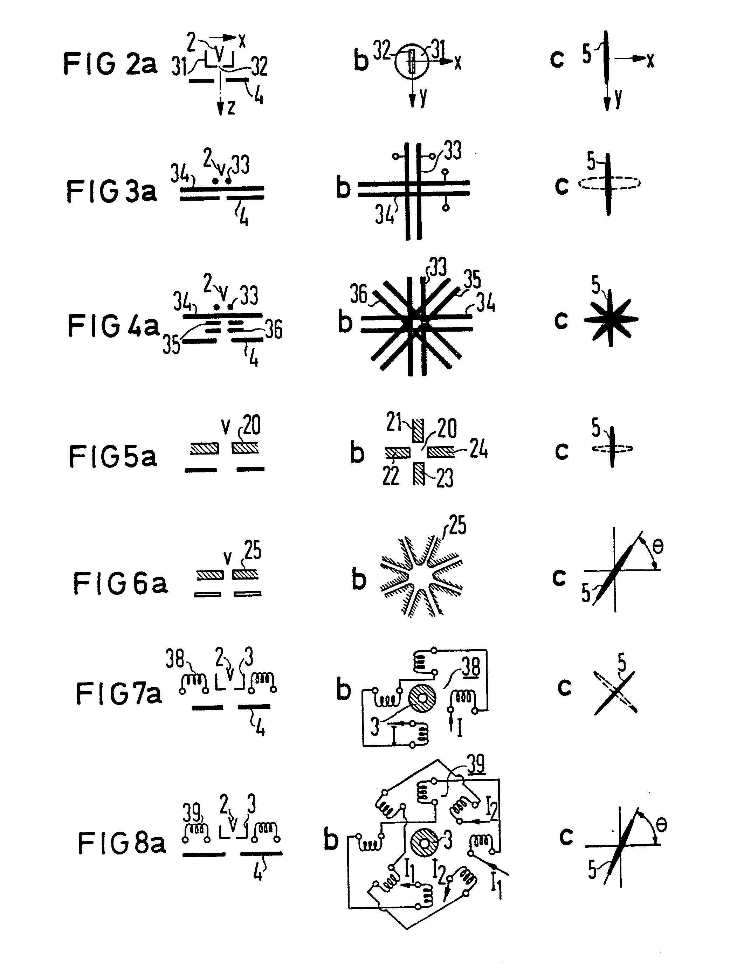

Fig. 3, 5, 7 zeigen verschiedene Quadrupol-Elemente, deren Wirkungsweise das Verständnis der erfindungsgemäßen Oktupol-Systeme nach den Fig. 4, 6 und 8 erleichtert.

Gleiche Teile sind mit gleichen Bezugszeichen versehen.

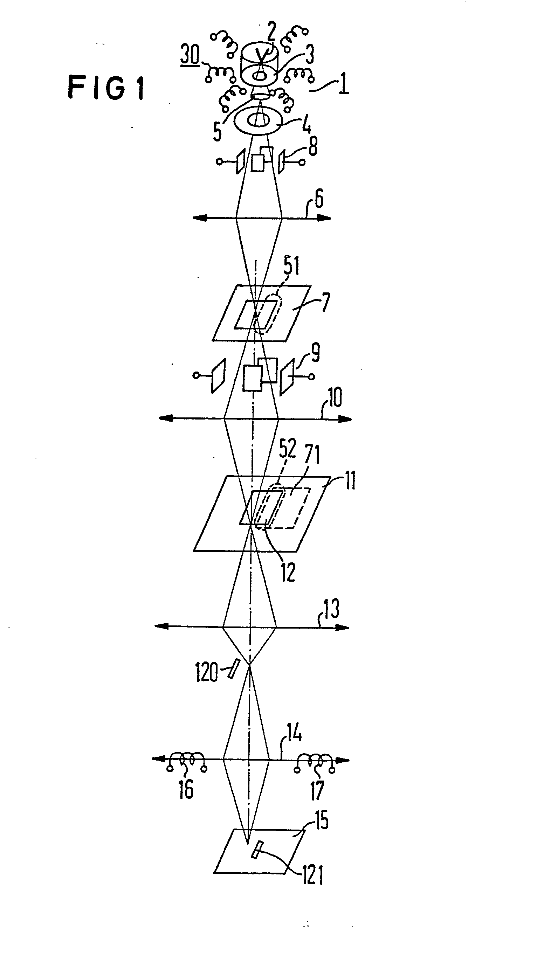

Fig. 1 zeigt schematisch ein aus Kathode 2, Wehnelt-Elektrode 3 und Anode 4 aufgebautes Strahlerzeugungssystem 1. Rund um die nichtferromagnetische Wehnelt-Elektrode 3 ist ein elektromagnetisches Hexapolelement 30 mit sechs Spulen angeordnet. Mit Hilfe dieses Elementes 30 kann im Kathodenraum ein linienförmiger cross-over 5 beliebiger azimutaler Lage erzeugt werden.

Mit einer ersten, nur durch einen Pfeil angedeuteten Beleuchtungslinse 6 wird dieser cross-over 5 auf eine erste Blende 7 abgebildet. Durch ein etwa in der vorderen Brennebene der Beleuchtungslinse 6 liegendes elektrostatisches Ablenksystem 8 kann das gestrichelt dargestellt Bild 51 des cross-over in seiner Lage verschoben werden.

Über ein weiteres Ablenksystem 9 und eine Linse 10 wird die Blende 7 auf eine weitere Blende 11 derart abgebildet, daß sich die Blende 11 und das Bild 71 der Blende 7 teilweise überlappen. Der Überlappungsbereich 12 ist mit dem Ablenksystem 9 einstellbar. Gestrichelt ist in der Ebene der Blende 11 das Bild 52 des cross-over-Bildes 51 angedeutet. Wie man aus dieser Figur ersehen kann, wird durch den linienförmigen cross-over dieser Überlappungsbereich 12 optimal ausgeleuchtet und durch eine Verkleinerungslinse 13 und eine Abbildungslinse 14 in die Wafer-Ebene 15 abgebildet. Die Bilder des Bereiches 12 sind dabei mit 120 und 121 bezeichnet. Durch die Spulen 16 und 17 ist ein zusätzliches Ablenksystem angedeutet, mit dem die erzeugten Strukturen in der Wafer-Ebene 15 verschoben werden können.

Der Vollständigkeit halber sei an dieser Stelle darauf hingewiesen, daß jede einzelne Linse auch durch eine Linsensystem ersetzt werden kann. Die Ablenksysteme können elektrostatisch oder magnetisch sein.

Im Strahlerzeugungssystem 1 ist zur Vermeidung einer unerwünschten Energieverbreiterung der cross-over 5 zu einer Linie verzerrt worden. Diese Verzerrung kann im Bedarfsfall rückgängig gemacht werden, indem z.B. für eine der nachfolgenden Linsen eine Zylinderlinse verwendet wird.

Fig. 2a zeigt im Schnitt entlang der xz-Ebene—z ist dabei die Elektronenstrahlrichtung—ein bekanntes Strahlerzeugungssystem mit einer Spitzenkathode 2, einer Wehnelt-Elektrode 31 mit einer schlitzförmigen Öffnung 32 für den Elektronenstrahl und einer Anode 4. Fig. 2b zeigt die Wehnelt-Elektrode 31 in der xy-Ebene, d.h. in Draufsicht. Die schlitzförmige Öffnung 32 besitzt eine langgestreckte Richteckform. Fig. 2c zeigt den sich mit dieser Wehnelt-Elektrode 31 durch astigmatische Fokussierung ergebenden ersten cross-over 5, in dem die Coulomb-Wechselwirkung zwischen den noch langsamen Elektronen herabgesetzt ist.

Wollte man bei diesem bekannten Strahlerzeugungssystem den cross-over in der xy-Ebene drehen, so müßte entweder das ganze Strahlerzeugungssystem oder zumindest die Wehnelt-Elektrode 31 gedreht werden, d.h. es müßte ein mechanischer Eingriff in der Hochstrom-Elektronenquelle vorgenommen werden.

Fig. 3a zeigt ein Quadrupol-Element in der gleichen Darstellung wie in der Fig. 2a, Dieses Quadrupol-Element besteht in diesem Beispiel aus zwei gekreuzten Zylinderlinsen 33 und 34, die aus je zwei auf Wehnelt-Potential liegenden Drähten bestehen können.

Fig. 3b zeigt die entsprechende Anordnung des Quadrupol-Elementes in Draufsicht. Durch Umschalten von einer Zylinderlinse 33 auf die andere 34 kann der linienförmige cross-over 5 um 90° gedreht werden, wie gestrichelt in Fig. 3c zusätzlich dargestellt ist.

Fig. 4 zeigt eine Wehnelt-Elektrode mit vier um jeweils 45° gegeneinander verdrehten Zylinderlinsen 33 bis 36 zur Erzeugung eines linienförmigen cross-over in der wahlweisen azimutalen Lage 0°, 45°, 90° oder 135° (Fig. 4c).

Die Fig. 5 zeigt ein weiteres Quadrupol-Element 20. Diese Anordnung entspricht in ihrer Wirkung der mit zwei Zylinderlinsen gemäß Fig. 3. Auch hier kann durch paarweises Umschalten der Quadrupolelemente 21 bis 24 der cross-over gedreht werden.

Fig. 6 zeigt die entsprechende Anordnung mit einem Oktupolelement 25, mit dessen Hilfe allein durch Wahl des Spannungsquotienten $U_2/U_1$—$U_1$ und $U_2$ sind betragsmäßig die Spannungen an zwei Quadrupolelementen, die ineinandergeschachtelt das Oktupolelement bilden—der cross-over um einen beliebigen Winkel $\theta$ gedreht werden kann.

Fig. 7 zeigt eine Wehnelt-Elektrode 3, wie sie auch in Fig. 1 verwendet wurde, mit einer kreisförmigen Durchtrittsöffnung für den Elektronenstrahl sowie ein elektromagnetisches Quadrupolelement 38 mit vier in Reihe geschalteten, in einer Ebene um die Wehnelt-Elektrode 3 symmetrisch angeordneten Spulen. Durch Stromumkehr läßt sich die Richtung des cross-over 5 wieder um 90° drehen. Durch die Größe des Stromes kann I seine Form verändert werden.

Fig. 8 schließlich zeigt eine entsprechende Anordnung mit einem elektromagnetischen Oktupolelement 39, mit dessen Hilfe die Richtung des cross-over 5 wie bei dem elektrostatischen Oktupolelement belibig gedreht werden kann.

Wie bereits anhand der Fig. 1 erläutert, ist es in vielen Fällen sehr vorteilhaft, diesen linienförmigen cross-over 5 beizubebehalten und ihn dabei in seiner Richtung und in seiner Größe nachfolgenden abzubildenden Strukturen anzugleichen.

## Patentansprüche

1. Hochstrom-Elektronenquelle kleiner Energiebreite, insbesondere für einen Elektronenstrahl-Schreiber, mit einem Strahlerzeugungssystem aus einer Kathode (2) und weiteren Elektroden, von denen eine als Wehnelt-Elektrode (3) die aus der Kathode austretenden, noch geringe Geschwindigkeiten aufweisenden Elektronen astigmatisch in eine linienförmige Kreuzungslinie (cross-over) (5) fokussiert, dadurch gekennzeichnet, daß die Wehnelt-Elektrode ein Oktupol-System (33 bis 36; 25; 39) ist, mit dem die linienförmige Kreuzungslinie (5) in beliebiger azimutaler Lage erzeugbar ist, und daß eine die linienförmige Kreuzungslinie (5) auf einer Blende (7) abbildende Beleuchtungslinse (6) sowie ein diese Abbildung der Kreuzungslinie (5) lateral verschiebendes Abbildungssystem (8) vorgesehen sind.

2. Hochstrom-Elektronenquelle nach Anspruch 1, dadurch gekennzeichnet, daß das Oktupol-System aus vier um jeweils 45° gegeneinander verdrehten Zylinderlinsen (33 bis 36) besteht.

3. Hochstrom-Elektronenquelle nach Anspruch 1, dadurch gekennzeichnet, daß das Oktupol-System (25) aus zwei um 45° gegeneinander verdrehten elektrostatischen Quadrupol-Elementen zusammengesetzt ist, deren Potentiale unabhängig voneinander veranderbar sind.

4. Hochstrom-Elektronenquelle nach Anspruch 1, dadurch gekennzeichnet, daß das Oktupol-System (39) aus zwei um 45° gegeneinander verdrehten elektromagnetischen Quadrupol-Elementen aufgebaut ist, die von unabhängig voneinander regelbaren Strömen durchflossen sind, und die eine Elektrode (3), die aus nicht-ferromagnetischem Material mit einer Öffnung für den Elektronenstrahl besteht, umgeben.

## Revendications

1. Source d'électrons à haute intensité et à faible bande d'énergie, en particulier pour un enregistreur à faisceau d'électrons, avec un système de production de faisceau d'électrons comportant une cathode (2) et des électrodes supplémentaires parmi lesquelles l'une constituant l'électrode de Wehnelt (3) focalise astigmatiquement suivant une droite de croisement (cross-over) linéaire (5), caractérisée par le fait que l'électrode de Wehnelt est un système octopolaire (33 à 36; 25; 39) avec lequel la droite de croisement linéaire (5) est susceptible d'être produite dans une position azimutale quelconque, et qu'il est prévu une lentille d'éclairage (6) reproduisant la droite de croisement linéaire (5) sur un diaphragme (7), ainsi qu'un système de reproduction (8) décalant latéralement cette reproduction de la droite de croisement (5).

2. Source d'électrons à haute intensité selon la revendication 1, caractérisée par le fait que le système octopolaire est constitué par quatre lentilles cylindriques (33 à 36) décalées entre elles de 45°.

3. Source d'électrons à haute intensité selon la revendication 1, caractérisée par le fait que le système octopolaire (25) est constitué par deux éléments électrostatiques quadripolaires décalés entre eux de 45° et dont les potentiels sont modifiables indépendamment l'un de l'autre.

4. Source d'électrons à haute intensité selon la revendication 1, caractérisé par le fait que le système octopolaire (39) est constitué par deux éléments électrostatiques quadripolaires décalés entre eux de 45°, qui sont parcourus par des courants réglables indépendamment l'un de l'autre, lesdits éléments entourant ladite électrode de Wehnelt (3) qui est constituée avec un matériau non-ferromagnétique.

## Claims

1. A high current electron source of small energy spread, in particular for an electron beam recorder, having a beam generating system which consists of a cathode (2) and further electrodes, one of which serves as a Wehnelt-electrode (3) to astigmatically focus electrons from the cathode at low velocity, into a linear cross-over line (5), characterised in that the Wehnelt-electrode is an eight-pole system (33 to 36; 25; 39), by means of which the linear cross-over line (5) can be produced in any azimuthal position, and that there are provided an illuminating lens (6) which represents the linear cross-over line (5) on a diaphragm (7), and a representation system (8), which laterally displaces the representation of the cross-over line (5).

2. A high current electron source as claimed in Claim 1, characterised in that the eight-pole system consists of four cylindrical lenses (33 to 36) respectively rotated by 45° in relation to one another.

3. A high current electron source as claimed in Claim 1, characterised in that the eight-pole system (25) is composed of two electro-static four-rupole elements which are rotated by 45° in relation to one another and whose potentials can be changed independently of one another.

4. A high current electron source as claimed in Claim 1, characterised in that the eight-pole system (39) is composed of two electromagnetic four-rupole elements which are rotated by 45° in relation to one another and which are traversed by currents which can be controlled independently of one another, and which elements surround one electrode (3) of a non-ferromagnetic material having an opening for the electron beam.

FIG 1

FIG 2a

b

c

FIG 3a

b

c

FIG 4a

b

c

FIG 5a

b

c

FIG 6a

b

c

FIG 7a

b

c

FIG 8a

b

c